# FASCICULE DE BREVET EUROPEEN

(11) **EP 0 669 622 B1**
(45) Date de publication et mention de la délivrance du brevet: **16.10.1996**
(21) Numéro de dépôt: 95470006.8
(22) Date de dépôt: 23.02.1995
(51) Int. Cl.: G06F 11/20, G11C 16/06

(54) **Circuit de polarisation pour transistor dans une cellule de mémorisation**
Vorspannungsschaltung für einen Transistor in einer Speicherzelle
Bias circuit for a transistor in a memory cell

(30) Priorité: 28.02.1994 FR 9402556
(43) Date de publication de la demande: 30.08.1995
(73) Titulaire: SGS-THOMSON MICROELECTRONICS S.A., F-94250 Gentilly (FR)
(72) Inventeur: Drouot, Sylvie, F-57000 Metz (FR)
(74) Mandataire: Schmit, Christian Norbert Marie

(56) Documents cités:
- EP-A- 0 516 225
- GB-A- 2 200 265
- US-A- 5 138 190
- IEEE JOURNAL OF SOLID-STATE CIRCUITS, vol.20, no.5, Octobre 1985, NEW YORK US pages 979 - 985 C.S. BILL 'A Temperature- and Process-Tolerant 64K EEPROM'

## Description

L'invention concerne les circuits intégrés, et elle concerne plus précisément la réalisation d'un circuit de polarisation permettant de modifier de façon temporaire l'accès à des cellules de mémorisation programmables. De telles cellules sont notamment utilisées dans le domaine des mémoires mortes organisées matriciellement, dans lesquelles les cellules de mémorisation comprennent un transistor à grille flottante comme organe de mémorisation.

Les mémoire mortes sont communément organisées matriciellement, en lignes et en colonnes. Les lignes sont dites des lignes de bit. Les colonnes sont dites des colonnes de mots. Les intersections de ces lignes et ces colonnes forment des points de mémorisation dont l'état électrique représente une information. Suivant la technologie employée, ces points de mémorisation seront programmables une ou plusieurs fois, effaçables individuellement ou globalement etc. La programmation et l'effacement sont des opérations qui consistent à imposer une certaine tension sur ces points de mémorisation, l'état électrique de ces derniers étant éventuellement modifié lors de ces opérations.

Les lignes et les colonnes des mémoires sont généralement testées en sortie de chaîne de fabrication afin de vérifier leur fonctionnement. Il s'agit notamment de s'assurer du fait qu'on peut accéder à tous les points de mémorisation des mémoires, et qu'on peut les programmer et les effacer d'une manière telle qu'on connaît de manière certaine, à tout moment, l'état électrique des cellules de mémorisation. Il arrive que certaines colonnes présentent des défauts de fabrication. Il se peut qu'il soit impossible d'y accéder. Il se peut aussi que les informations qu'on serait amené à y stocker ne soient pas fiables, si par exemple leur état électrique demeure identique alors qu'il devrait être modifié par programmation ou effacement. Il est dans ce cas préférable de ne pas les utiliser. On prévoit donc couramment d'utiliser des colonnes supplémentaires, dites de redondance, pour pallier aux éventuelles défaillances des colonnes mises à la disposition des utilisateurs. Si aucune défaillance n'est détectée en sortie de chaîne de fabrication, ces colonnes de redondance sont inutilisées.

Le nombre des colonnes de redondance est fonction de l'encombrement maximal autorisé, et des probabilités de défaillance qui dépendent de paramètres technologiques. Par exemple, pour une mémoire comportant 8192 colonnes organisées en 32 blocs de 256 colonnes, on peut décider d'ajouter 4 colonnes de redondance par bloc. Cela fait au total 128 colonnes de redondance.

Pour pouvoir effectivement remplacer une colonne défaillante par une colonne de redondance, il faut prévoir des moyens pour mémoriser l'adresse de la colonne défaillante et pour sélectionner la colonne de redondance quand on sélectionne l'adresse de la colonne défaillante. Auparavant, on procédait à une coupure physique de fils, typiquement à l'aide de lasers. Cette opération devait être effectuée avant passivation de la mémoire et imposait de retourner en fabrication pour la passivation, une fois le remplacement effectué.

A l'heure actuelle, afin de simplifier l'opération, on utilise des circuits programmables afin de mémoriser électriquement dans des circuits de mémorisation les adresses des colonnes de redondance.

Un circuit de mémorisation comporte typiquement un transistor à grille flottante qui sert de cellule de mémorisation. Un transistor à grille flottante représente un bit d'adresse. Ce transistor à grille flottante, appelé communément fusible, est monté en série avec une source de courant. L'expression fusible est fonctionnelle et imagée. Elle ne met pas forcément en oeuvre une fusion de matière.

Selon son état électrique (présence ou non d'électrons sur la grille flottante), le fusible se comporte comme un circuit ouvert ou comme une résistance. Si il se comporte comme une résistance, il peut être traversé par un courant. Par contre, si il se comporte comme un circuit ouvert, il ne peut pas être traversé par un courant. On procède donc à la lecture des adresses des colonnes de redondance à l'aide de détecteur de courant.

Dans l'exemple décrit ci-dessus, on code les adresses sur 13 bits. On dispose donc en tout de 1664 bits d'adresse de colonne de redondance. Si on rajoute un bit supplémentaire de validation, afin de ne lire que les adresses correspondant aux colonnes de redondance effectivement utilisées, on peut lire jusqu'à 1792 bits, chacun étant matérialisé par un fusible.

Pour programmer un fusible, on l'isole de la source de courant correspondante. A cette fin, on utilise au moins un transistor d'isolation, monté en série entre ce fusible et cette source de courant. Quand on est en programmation le transistor d'isolation est bloqué et aucun courant ne passe de la source de courant vers le fusible.

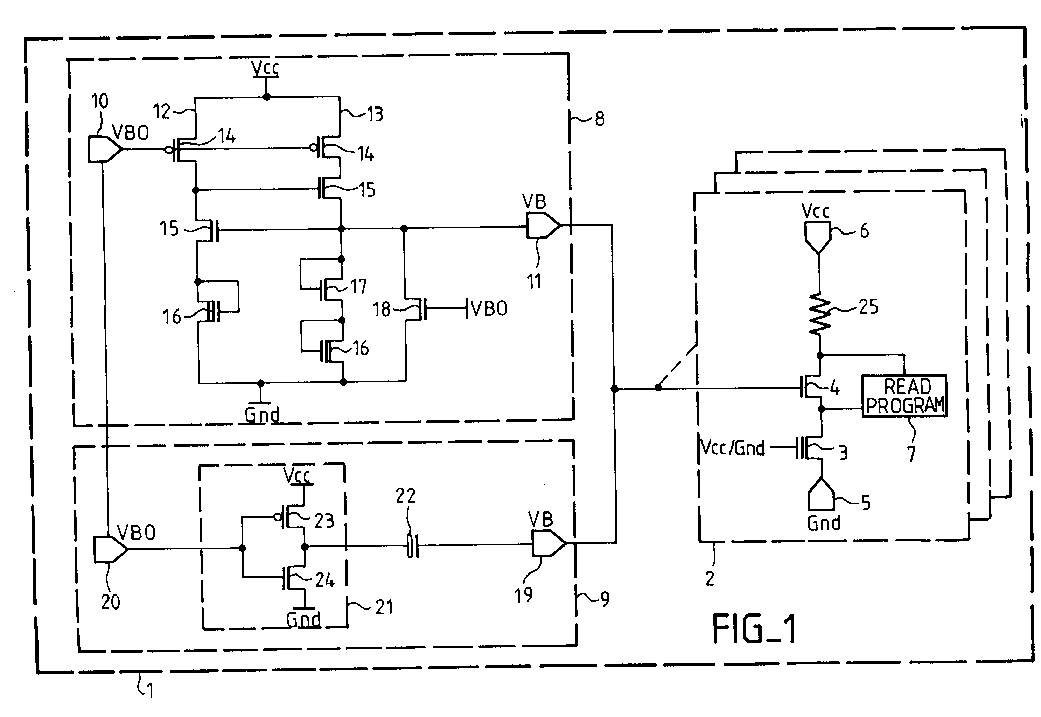

Un circuit de mémorisation 2 de ce type est reconnaissable sur la figure 1. Cette figure concerne l'invention mais montre également l'état de la technique.

Un transistor à grille flottante 3 (fusible), dont la source est connectée à une masse 5, est monté en série avec un transistor 4 de type N dont le drain est connecté à une borne d'alimentation 6 par le biais d'une résistance 25.

Le drain du transistor à grille flottante est connecté à un circuit 7 permettant d'imposer une tension.

Le fonctionnement de ce circuit est le suivant :
- en mode de programmation, suivant l'état électrique désiré, on impose ou non une tension de forte valeur (par exemple 10 volts) sur le drain du transistor à grille flottante afin d'injecter ou non des électrons sur la grille flottante, sa grille de commande étant connectée à une masse, et la grille de commande du transistor d'isolation étant connectée à la masse.
- en mode de détection de passage de courant (lecture du bit d'adresse), le transistor d'isolation de type N est polarisé positivement sur sa grille de commande afin d'être passant, la grille de commande du transistor à grille flottante étant connectée à un potentiel d'alimentation positif VCC fournie par la borne d'alimentation. La détection s'effectue par un circuit connecté au drain du transistor d'isolation.

Quant on est en mode de lecture le transistor d'isolation est passant et un courant peut éventuellement passer, suivant l'état électrique du transistor à grille flottante.

Le transistor d'isolation sert à imposer une tension constante sur le drain du transistor à grille flottante pour avoir les mêmes conditions de lecture quel que soit le courant fourni par la borne d'alimentation. Dans ce cas, le courant lu est seulement fonction de la tension de seuil du transistor à grille flottante, cette tension de seuil variant suivant l'état électrique de ce transistor.

Pour imposer une tension constante sur le drain du transistor à grille flottante, on impose une tension de polarisation constante au niveau des transistors d'isolation. Cette tension est typiquement de l'ordre de deux fois la tension de seuil Vt d'un transistor d'isolation (typiquement Vt = 1V). On choisit une tension de polarisation faible afin de limiter le courant produit et donc la consommation du circuit.

Cette limitation nécessite donc la présence d'un circuit de polarisation. Ce circuit de polarisation doit également pouvoir fournir une tension adéquate en mode de programmation (connexion à la masse de la grille de commande des transistors d'isolation).

Il est préférable, pour des raisons de rapidité de temps d'accès, de lire en permanence les états des fusibles (du moins de ceux représentant les adresses de colonnes de redondance utilisées). Cela pose un problème de consommation. En effet, quel que soit le mode de fonctionnement utilisé, le circuit de polarisation doit fonctionner. C'est le cas par exemple dans un mode de veille dans lequel la mémoire est alimentée mais non utilisée (pas de lecture, pas d'écriture). Ce circuit de polarisation doit donc fonctionner le moins possible. D'un autre côté, il doit être rapide lors de l'activation de la mémoire (lecture et écriture possibles).

Une évolution actuelle tend à développer des circuits intégrés fonctionnant avec des valeurs de tension d'alimentation variables. Par exemple, on développe des circuits pouvant fonctionner aussi bien avec une tension d'alimentation de 3 volts qu'avec une tension d'alimentation de 5 volts. Or le circuit de polarisation doit pouvoir fournir rapidement la tension de polarisation positive (typiquement en un temps inférieur à 1 µs). En effet, après une mise sous tension, ou après une phase de programmation, il se peut qu'on cherche à accéder à une colonne qui s'avère défaillante.

On connaît des circuits de polarisation rapides et consommant peu, fonctionnant sous 5 volts. Néanmoins, ceux-ci ne sont pas adaptés pour de faibles tensions d'alimentation (3 volts), leur temps de montée étant alors trop faible (c'est-à-dire supérieur à 1 µs). L'ensemble des circuits de mémorisation peut en effet être assimilé à une capacité de quelques picofarads. Ces circuits de polarisation ne sont donc pas adaptés pour des circuits à tension d'alimentation variable.

L'invention a pour but de proposer un circuit intégré comportant des circuits de mémorisation tels que définis précédemment, et des moyens pour fournir une tension de polarisation aux transistors d'isolation, ces moyens consommant peu pour des tensions d'alimentation de l'ordre de 5V, et ayant une constante de temps de réponse relativement rapide pour des tensions d'alimentation de l'ordre de 3V.

L'invention a donc pour objet un circuit intégré comprenant des circuits de mémorisation, un premier circuit de polarisation comprenant au moins une borne de commande pour recevoir un premier signal binaire de commande, et une borne de sortie pour fournir une tension binaire de polarisation aux circuits de mémorisation, cette tension prenant une première valeur quand le premier signal de commande est dans un premier état, et une deuxième valeur quand ledit signal de commande est dans un second état, caractérisé en ce qu'il comprend un deuxième circuit de polarisation qui comprend au moins une borne de commande pour recevoir un second signal binaire de commande, et une borne de sortie pour fournir une tension binaire de polarisation aux circuits de mémorisation, cette tension prenant une première valeur quand le second signal de commande est dans un premier état, et une deuxième valeur quand ledit second signal de commande est dans un second état, et en ce que la constante de temps du deuxième circuit en réponse à un changement d'état du second signal de commande est inférieure à la constante de temps du premier circuit en réponse à un changement d'état du premier signal de commande.

Ainsi, l'invention propose d'utiliser un premier circuit de polarisation tel qu'on en connaît dans l'état de la technique et apte à fournir une tension de polarisation (2 Vt) stable et précise, en lui adjoignant un deuxième circuit de polarisation ayant une constante de temps de réponse plus rapide, afin d'accélérer le temps de réponse du premier circuit de polarisation.

Ce résultat est atteint d'une manière préférée en utilisant un deuxième circuit de polarisation comprenant un condensateur série en sortie, créant ainsi un diviseur de tension capacitif avec la capacité équivalente de l'ensemble des circuits de mémorisation.

Les caractéristiques et avantages de l'invention apparaîtront à la lecture de la description détaillée qui suit, d'un mode de réalisation préféré, et qui est faite en référence aux dessins annexés dans lesquels :
- la figure 1 représente un circuit conforme à l'invention,
- les figures 2a, 2b, 2c, représentent des diagrammes temporels représentatifs des réponses des circuits de polarisation pris isolément ou concurremment, en réponse un échelon de tension.

La figure 1 montre un circuit intégré 1 réalisé conformément à l'invention. Il sera par exemple réalisé en technologie MOS. Celui-ci comprend des circuits de mémorisation 2, non tous représentés. Ces circuits de mémorisation 2 comprennent une cellule dite fusible. Dans l'exemple décrit, un fusible est un transistor à grille flottante 3 monté en série avec un transistor d'isolation 4 de type N entre une borne de référence 5 et une borne d'alimentation 6. Typiquement, la borne de référence 5 fournit un potentiel de masse GND et la borne d'alimentation 6 fournit un potentiel d'alimentation positif VCC de l'ordre de quelques volts (3 à 5 volts).

Le transistor à grille flottante 3 est connecté par sa grille de commande, par le biais d'un circuit non représenté, soit au potentiel de masse GND, soit au potentiel d'alimentation VCC. Sa source est connectée à la borne de masse 5 et son drain est connecté à la source du transistor d'isolation 4. Le transistor d'isolation 4 a son drain connecté à une résistance 25 elle-même connectée à la borne d'alimentation 6.

Le drain du transistor à grille flottante 3 est connecté à un circuit de programmation et de lecture 7, qui est connecté également au drain du transistor d'isolation 4. Ce circuit 7, dans un premier mode dit de programmation, peut fournir une tension de quelques volts au transistor à grille flottante 3, la grille de commande de celui-ci étant connectée à la masse. Dans un deuxième mode dit de lecture, ce circuit 7 peut détecter un éventuel passage de courant dans la résistance 25 et donc dans le transistor à grille flottante 3. Ce passage est fonction de l'état électrique du transistor à grille flottante 3 (présence ou non d'électrons sur la grille flottante).

Le circuit intégré 1 comporte également deux circuits de polarisation 8 et 9.

Le premier circuit de polarisation 8, connu dans l'état de la technique, comporte une borne de commande 10 et une borne de sortie 11. Il se compose de deux branches composées de transistors montés en série entre la borne d'alimentation 6 et la borne de masse 5.

Une première branche 12 comporte un premier transistor 14 de type P dont la source est connectée à la borne d'alimentation 6, et dont le drain est connecté au drain d'un premier transistor 15 de type N. La source de ce premier transistor 15 de type N est connectée au drain et à la grille de commande d'un deuxième transistor 16 de type N, monté en diode, dont la source est connectée à la borne de masse 5.

La deuxième branche 13 du premier circuit de polarisation 8 est analogue à la première, si ce n'est qu'un transistor de type N supplémentaire 17 est monté en diode entre respectivement la source et le drain des transistors correspondant respectivement au premier et au deuxième transistors 15 et 16 de type N de la première branche 12.

Les grilles de commande des transistors de type P 14 sont connectées à la borne de commande 10.

La grille de commande du premier transistor de type N 15 de la deuxième branche 13 est connectée au drain du transistor de type P 14 de la première branche 12.

La grille de commande du premier transistor de type N 15 de la première branche 12 est connectée à la source du premier transistor de type N 15 de la deuxième branche 13. Cette source est également connectée à la borne de sortie 11.

Le premier circuit de polarisation 8 comprend par ailleurs un transistor de type N 18 monté en sortie entre la borne de sortie 11 et la borne de masse 5. Ce transistor de type N de sortie 18 a sa grille de commande connectée à la borne de commande 10.

La borne de commande 10 reçoit un premier signal binaire de commande VB0. La borne de sortie 11 fournit une tension binaire de polarisation VB aux circuits de mémorisation 2. Cette tension VB prend une première valeur quand le premier signal de commande VB0 est dans un premier état (VB0 = 1), et une deuxième valeur quand le dit signal de commande VB0 est dans un second état (VB0 = 0).

Si on appelle Vt la tension de seuil d'un transistor d'isolation 4, la première valeur de VB est égale au potentiel de masse GND et la deuxième valeur de VB est égale typiquement à 2 * Vt. La première valeur de VB correspond à l'isolement du transistor à grille flottante 3 de la source de courant formé par la résistance 25 et la borne d'alimentation 6 (mode de programmation). La deuxième valeur de VB correspond à la connexion du transistor à grille flottante 3 à cette source de courant (mode de lecture).

Ce premier circuit de polarisation 8 est une source de tension commandée en courant (si VB0 = 0 bien sûr). Le transistor de type P 14 de la première branche 12 et le premier transistor de type N 15 de la deuxième branche 13 sont équivalents à des résistances. Par exemple, si le premier transistor de type N 15 passe plus de courant, alors il y a une chute de tension dans le transistor de type P 14 de la première branche 12, donc une chute du potentiel de la grille de commande du premier transistor de type N 15 de la deuxième branche 13. Le courant traversant ce transistor tend à diminuer et la tension VB chute sur la borne de sortie 11. Ainsi, par contre-réaction, on est assuré de disposer d'une tension de polarisation VB précise et stable.

Les transistors 16 et 17 montés en diode sur la deuxième branche 13 entre la borne de sortie 11 et la borne de masse 5 permettent de fixer la tension de polarisation VB à une valeur équivalente à deux tensions de seuil Vt quand VB0 = 0.

Le transistor de type N 18 de sortie permet de connecter rapidement la borne de sortie 11 au potentiel de masse GND lorsqu'on coupe la connexion entre les transistors à grille flottante 3 des circuits de mémorisation 2 et les sources de courant correspondantes (VB0 = 1). D'autre part, il permet d'être sûr de la valeur de la tension VB présente à ce moment là sur la borne de sortie 11. En effet, il se pourrait qu'on se retrouve avec un noeud flottant à cet endroit, par effet capacitif parasite.

Le circuit intégré 1 comprend un deuxième circuit de polarisation 9. Ce circuit comprend une borne de sortie 19 et une borne de commande 20.

L'entrée d'un inverseur 21 est connectée à la borne de commande 20. La sortie de cet inverseur 21 est connectée à la borne de sortie 19 par le biais d'un condensateur 22.

On réalise l'inverseur 21 de manière classique en montant deux transistors 23 et 24 de type respectivement P et N en série entre une borne d'alimentation 6 et une borne de référence 5.

La borne de commande 20 du deuxième circuit de polarisation reçoit un second signal binaire de commande VB0. La borne de sortie 19 de ce deuxième circuit de polarisation fournit une tension binaire de polarisation VB aux circuits de mémorisation 2. Cette tension de polarisation VB prend une première valeur quand le second signal de commande VB0 est dans un premier état (VB0 = 1), et une deuxième valeur quand le dit second signal de commande VB0 est dans un second état (VB0 = 0).

Dans l'exemple préféré décrit, la borne de sortie 19 et la borne de commande 20 du deuxième circuit de polarisation 9 sont connectées à celles du premier circuit de polarisation 8. De même, les bornes d'alimentation 6 et de masse 5 employées par les deux circuits de polarisation 8 et 9 sont identiques. On pourrait très bien imaginer que ces deux circuits de polarisation 8 et 9 soient connectés à deux bornes d'alimentation fournissant des tensions d'alimentation différentes, suivant la tension de polarisation VB souhaitée en sortie du deuxième circuit de polarisation 9.

Schématiquement, on peut représenter le premier circuit de polarisation 8 pris isolément par une source de tension montée en série avec un circuit RC. Typiquement, C vaut une dizaine de picofarads si on considère l'exemple considéré. Le premier circuit de polarisation 8 est caractérisé par une constante de temps t1 = R * c et un gain G1 = VB/VCC = 2 * Vt/VCC quand VB0 passe de l'état 1 à l'état 0.

En ce qui concerne le deuxième circuit de polarisation 9 pris isolément, en notant C' la capacité du condensateur 22 placée en sortie, on a une constante de temps qui vaut t2 = R * C * C'/(C + C') et un gain G2 = VB/VCC = C'/(C + C') quand VB0 passe de l'état 1 à l'état 0.

En notant k = C'/(C + C') alors t2 = k * t1, avec k < 1.

En prenant par exemple C' égal à 5 picofarads, la constante de temps t2 du deuxième circuit de polarisation 9 est trois fois plus faible que la constante de temps t1 du premier circuit de polarisation 8.

On a alors G2 = 1/3. Si VCC = 5V, alors VB = 1.67V pour le deuxième circuit de polarisation pris isolément. Si VCC = 3V, alors, dans les mêmes conditions, VB = 1V. Pour le premier circuit de polarisation 8 pris isolément la tension de polarisation VB est constante, que VCC vaille 3 ou 5 volts, et c'est le gain G1 qui varie.

On pourrait imaginer augmenter C' afin de disposer d'une tension de polarisation VB positive plus importante sur la borne de sortie 19 du deuxième circuit de polarisation 9 pris isolément. Néanmoins, ceci n'est pas conseillé, car cela augmenterait t2.

Utilisé concurremment avec le premier circuit de polarisation 8, le deuxième circuit 9 ne fournit donc pas la valeur de tension de polarisation (2 * Vt) nécessaire pour la lecture des transistors à grille flottante 3. En revanche, il permet de réduire le temps de montée du premier circuit de polarisation 8. En effet, les deux bornes de sortie 11 et 19 sont connectées et la borne de sortie 11 du premier circuit de polarisation 8 agit en contre réaction sur son entrée.

Dans un premier temps, quand VB0 passe de 1 à 0, le deuxième circuit de polarisation 9 tend à monter la tension VB à une valeur égale à G2 * VCC, avec une constante de temps t2. Dès que la tension VB tend à se stabiliser, et donc à évoluer moins vite que le premier circuit de polarisation 8 ne l'imposerait, seul, pour un niveau de tension de sortie équivalent, le premier circuit 8 prend la relève et monte la tension de sortie VB à la valeur désirée de 2 * Vt.

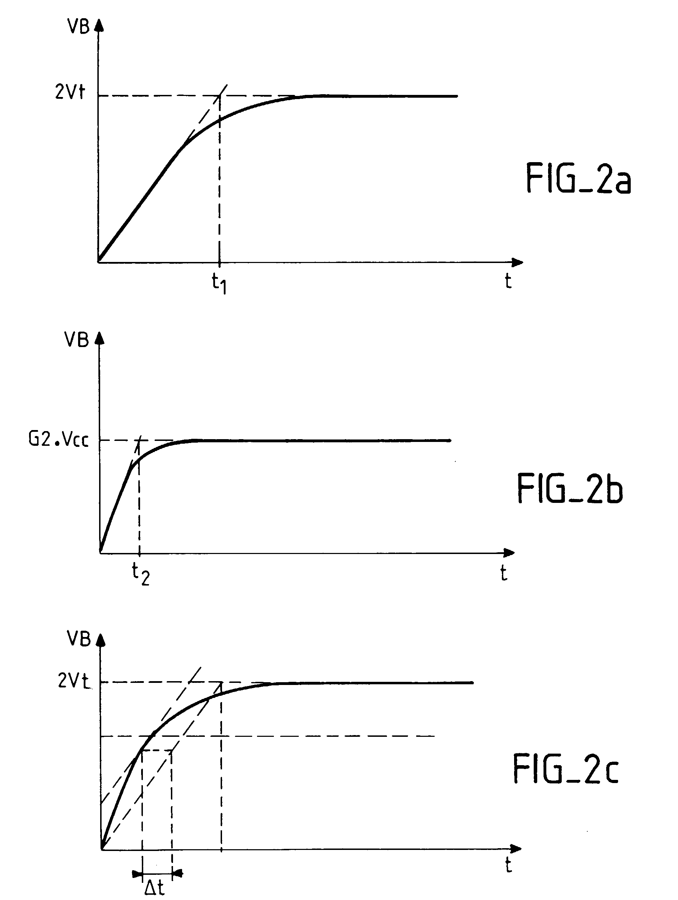

La figure 2a illustre l'évolution temporelle de la tension de sortie VB en réponse à un échelon (VB0 passant de 1 à 0), dans le cas d'un circuit de polarisation 8 agissant seul.

La figure 2b illustre l'évolution temporelle de la tension de sortie VB en réponse au même échelon, si on considère le deuxième circuit de polarisation 9 seul.

La figure 2c illustre l'évolution de la tension de sortie quand les deux circuits de polarisation 8 et 9 sont utilisés simultanément.

Le gain de temps Δt entre la figure 2a et la figure 2c est fonction du temps pendant lequel la valeur de la tension VB est fonction du deuxième circuit de polarisation 9.

Bien sûr, on pourrait envisager de procéder autrement pour obtenir un deuxième circuit de polarisation 9 présentant une constante de temps t2 réduite. Le deuxième circuit de polarisation 9, tel que décrit, a l'avantage d'être peu encombrant et de consommer peu. On pourrait néanmoins choisir de remplacer le condensateur série 22 de sortie par un circuit équivalent (inductance parallèle par exemple) sans sortir du cadre de l'invention.

## Revendications

1. Circuit intégré comprenant :
- des circuits de mémorisation (2),
- un premier circuit de polarisation (8) comprenant au moins une borne de commande (10) pour recevoir un premier signal binaire de commande (VB0), et une borne de sortie (11) pour fournir une tension binaire (VB) polarisation aux circuits de mémorisation (2), cette tension prenant une première valeur quand le premier signal de commande est dans un premier état, et une deuxième valeur quand le dit signal de commande est dans un second état,
caractérisé en ce qu'il comprend un deuxième circuit de polarisation (9) qui comprend au moins une borne de commande (20) pour recevoir un second signal binaire de commande (VB0), et une borne de sortie (19) pour fournir une tension binaire (VB) de polarisation aux circuits de mémorisation (2), cette tension prenant une première valeur quand le second signal de commande est dans un premier état, et une deuxième valeur quand le dit second signal de commande est dans un second état,
et en ce que la constante de temps (t2) du deuxième circuit (9) en réponse à un changement d'état du second signal de commande est inférieur à la constante de temps (t1) du premier circuit (8) en réponse à un changement d'état du premier signal de commande.

2. Circuit selon la revendication 1 caractérisé
en ce que le deuxième circuit de polarisation (9) comprend un condensateur série (22) en sortie.

3. Circuit selon l'une des revendications 1 à 2, caractérisé en ce que les bornes de sortie du premier et du deuxième circuits de polarisation sont connectées.

4. Circuit selon l'une des revendications 1 à 2, caractérisé en ce que les bornes de commande du premier et du deuxième circuits de polarisation sont connectées.

5. Circuit selon l'une des revendications 2 à 4, caractérisé en ce que le deuxième circuit de polarisation (9) comprend un inverseur (21) monté en série avec le condensateur (22) entre les bornes de commande (20) et de sortie (21) de ce circuit de polarisation (9).

6. Circuit selon l'une des revendications 1 à 5, caractérisé en ce que les circuits de mémorisation (2) comprennent un transistor à grille flottante (3) monté en série avec au moins un transistor d'isolation (4), entre une borne de référence (5) et une borne d'alimentation (6).

7. Circuit selon la revendication 6, caractérisé en ce que le transistor d'isolation (4) est un transistor de type N dont la grille de commande est connectée à au moins une borne de sortie d'un circuit de polarisation.

## Patentansprüche

1. Integrierte Schaltung mit:
- Speicherschaltungen (2)
- einer ersten Vorspannungsschaltung (8) mit wenigstens einem Steueranschluß (10) zum Empfangen eines ersten binären Steuersignals (VB0) und einem Ausgangsanschluß (11) zum Liefern einer binären Vorspannung (VB) an die Speicherschaltungen (2), wobei diese Vorspannung einen ersten Wert annimmt, wenn das erste Steuersignal in einem ersten Zustand ist, und einen zweiten Wert annimmt, wenn dieses Steuersignal in einem zweiten Zustand ist,
**dadurch gekennzeichnet**, daß
sie eine zweite Vorspannungsschaltung (9) umfaßt, die wenigstens einen Steueranschluß (20) zum Empfangen eines zweiten binären Steuersignals (VB0) und einen Ausgangsanschluß (19) zum Liefern einer binären Vorspannung (VB) an die Speicherschaltungen (2) umfaßt, wobei diese Vorspannung einen ersten Wert annimmt, wenn das zweite Steuersignal in einem ersten Zustand ist und einen zweiten Wert annimmt, wenn das zweite Steuersignal in einem zweiten Zustand ist, und
die Zeitkonstante (t2) der zweiten Schaltung (9) in Reaktion auf eine Zustandsänderung des zweiten Steuersignals kleiner als die Zeitkonstante (t1) der ersten Schaltung (8) in Reaktion auf eine Zustandsänderung des ersten Steuersignals ist.

2. Integrierte Schaltung nach Anspruch 1, dadurch gekennzeichnet, daß die zweite Vorspannungsschaltung (9) am Ausgang einen in Reihe geschalteten Kondensator (22) aufweist.

3. Schaltung nach einem der Ansprüche 1 bis 2, dadurch gekennzeichnet, daß die Ausgangsanschlüsse der ersten und der zweiten Vorspannungsschaltung verbunden sind.

4. Schaltung nach einem der Ansprüche 1 bis 2, dadurch gekennzeichnet, daß die Steueranschlüsse der ersten und der zweiten Vorspannungsschaltung verbunden sind.

5. Schaltung nach einem der Ansprüche 2 bis 4, dadurch gekennzeichnet, daß die zweite Vorspannungsschaltung (9) einen in Reihe mit dem Kondensator (22) geschalteten Inverter (21) zwischen dem Steueranschluß (20) und dem Ausgangsanschluß (21) dieser Vorspannungsschaltung (9) aufweist.

6. Schaltung nach einem der Ansprüche 1 bis 5, dadurch gekennzeichnet, daß die Speicherschaltungen (2) einen Transistor mit offenem Gate (3) in Reihenschaltung mit wenigstens einem Trenntransistor (4) zwischen einem Referenzanschluß (5) und einem Versorgungsanschluß (6) aufweisen.

7. Schaltung nach Anspruch 5, dadurch gekennzeichnet, daß der Trenntransistor (4) ein N-Transistor ist, dessen Steuergate an wenigstens einen Ausgangsanschluß einer Vorspannungsschaltung angeschlossen ist.

## Claims

1. Integrated circuit comprising:
- storage circuits (2),
- a first bias circuit (8) comprising at least one control terminal (10) for receiving a first binary control signal (VB0) and one output terminal (11) for supplying a biasing binary voltage (VB) to the storage circuits (2), this voltage taking a first value when the first control signal is in a first state, and a second value when the said control signal is in a second state,
characterised in that it comprises a second bias circuit (9) which comprises at least one control terminal (20) for receiving a second binary control signal (VB0), and one output terminal (19) for supplying a biasing binary voltage (VB) to the storage circuits (2), this voltage taking a first value when the second control signal is in a first state, and a second value when the said second control signal is in a second state,
and in that the time constant (t2) of the second circuit (9) in response to a change in state of the second control signal is less than the time constant (t1) of the first circuit (8) in response to a change in state of the first control signal.

2. Circuit according to Claim 1, characterised in that the second bias circuit (9) comprises a series capacitor (22) at the output.

3. Circuit according to one of Claims 1 to 2, characterised in that the output terminals of the first and second bias circuits are connected.

4. Circuit according to one of Claims 1 to 2, characterised in that the control terminals of the first and second bias circuits are connected.

5. Circuit according to one of Claims 2 to 4, characterised in that the second bias circuit (9) comprises an inverter (21) mounted in series with the capacitor (22) between the control (20) and output (21) terminals of this bias circuit (9).

6. Circuit according to one of Claims 1 to 5, characterised in that the storage circuits (2) comprise a floating gate transistor (3) mounted in series with at least one isolation transistor (4), between a reference terminal (5) and a supply terminal (6).

7. Circuit according to Claim 6, characterised in that the isolation transistor (4) is an n-type transistor whose control gate is connected to at least one output terminal of a bias circuit.
